Europäisches Patentamt

European Patent Office

Office européen des brevets

(11) Veröffentlichungsnummer: **0 354 478 B1**

(12) **EUROPÄISCHE PATENTSCHRIFT**

(45) Veröffentlichungstag der Patentschrift: **16.12.92**

(21) Anmeldenummer: **89114363.8**

(22) Anmeldetag: **03.08.89**

(51) Int. Cl.⁵: **H01L 27/02**, H03K 17/687

(54) **Gate-Source-Schutzschaltung für einen Leistungs-MOSFET.**

(30) Priorität: **10.08.88 DE 3827164**

(43) Veröffentlichungstag der Anmeldung:
**14.02.90 Patentblatt 90/07**

(45) Bekanntmachung des Hinweises auf die
Patenterteilung:
**16.12.92 Patentblatt 92/51**

(84) Benannte Vertragsstaaten:
**DE FR GB IT SE**

(56) Entgegenhaltungen:

**PATENT ABSTRACTS OF JAPAN, Band 11,
Nr. 165 (E-510)[2612], 27. Mai 1987; & JP-A-61
296 770**

**ELEKTRONIK, Band 35, Nr. 11, Mai 1986, Seiten 123-124, München, DE; B.E. TAYLOR:
"Leistungs-MOSFET-module für hohe Ströme"**

(73) Patentinhaber: **SIEMENS AKTIENGESELL-
SCHAFT
Wittelsbacherplatz 2
W-8000 München 2(DE)**

(72) Erfinder: **Leipold, Ludwig, Dipl.-Ing.
Strassberger Strasse 125
W-8000 München 40(DE)**
Erfinder: **Sander, Rainald, Dipl.-Phys.
Karl-Theodor-Strasse 25
W-8000 München 40(DE)**
Erfinder: **Tihanyi, Jenoe, Dr.-Ing.
Windeckstrasse 1d
W-8000 München 70(DE)**
Erfinder: **Weber, Roland, Dipl.-Ing.
Ursulastrasse 5
W-8000 München 40(DE)**

## Beschreibung

Die Erfindung bezieht sich auf eine Schaltungsanordnung mit einem Leistungs-MOSFET und zwei anodenseitig verbundenen Zenerdioden, wobei der Katodenanschluß der ersten Zenerdiode mit dem Gateanschluß und der Katodenanschluß der zweiten Zenerdiode mit dem Sourceanschluß des Leistungs-MOSFET verbunden ist.

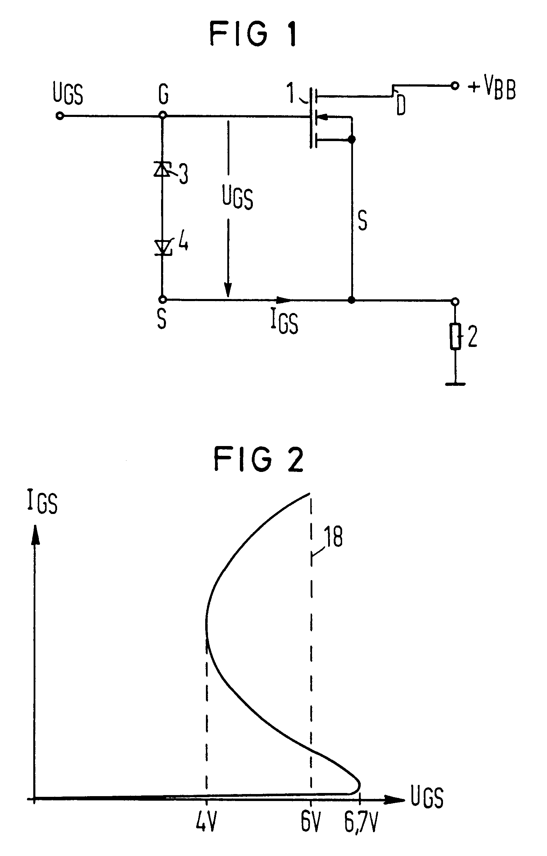

Diese Schaltung ist z.B. in dem Tagungsbericht "Untersuchungen an einem neuen MOSFET-Modul" von L.Lorenz, W.Schierz, H.Amann, der 3rd International Macroelectronics Conference, München, 13.11.1986, Seite 68 bis 84 beschrieben worden. Das Schaltungsprinzip ist in FIG 1 dargestellt. Zwischen dem Gateanschluß G und dem Sourceanschluß S eines Leistungs-MOSFET 1 liegen die beiden Zenerdioden 3 und 4. Sie schützen die Gate-Sourcekapazität des MOSFET 1 gegen positive und negative Überspannungen.

Wird dem MOSFET 1 sourceseitig eine Last 2 in Reihe geschaltet, so muß die Gate-Sourcespannung $U_{GS}$ höher als die Versorgungsspannung $V_{BB}$ werden, um den MOSFET 1 sicher leitend zu steuern. Sind die Zenerdioden 3, 4 in einem gemeinsamen Substrat integriert, ist ein sicheres Leitendsteuern des MOSFET 1 nicht gewährleistet. Die Strom/Spannungscharakteristik $I_{GS}/U_{GS}$ zeigt dann die in FIG 2 dargestellte Form. Mit steigendem Strom $I_{GS}$ steigt die Spannung $U_{GS}$ zunächst auf den Wert der Zenerspannung der Zenerdiode 3 zuzüglich der Durchlaßspannung der Zenerdiode 4, z.B. auf 6,7 Volt, an. Mit weiter steigendem Strom geht die Spannung z.B. auf einen Wert von 4 Volt zurück, um erst bei höheren Strömen wieder anzusteigen. Mit einer Spannung von 4 Volt läßt sich jedoch der MOSFET 1 oft nicht vollständig leitend steuern.

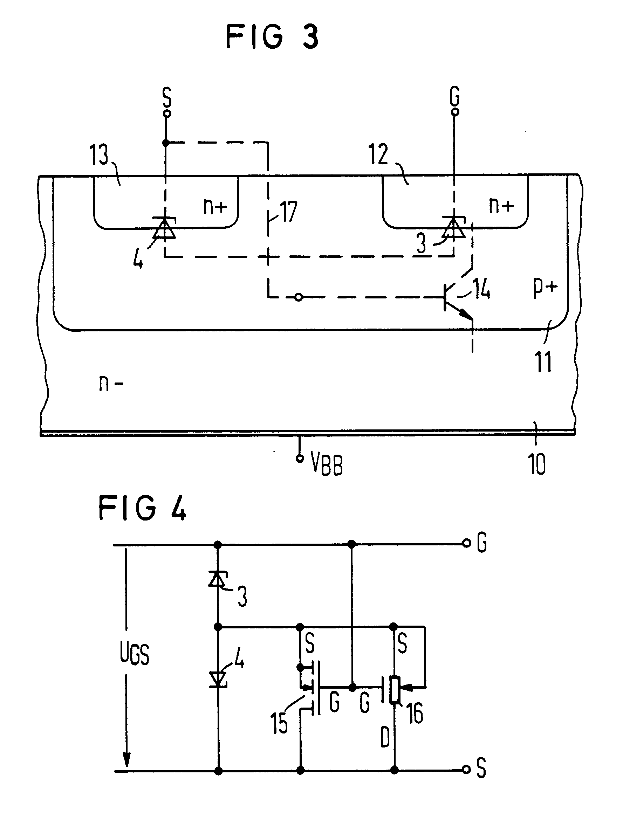

Die dargestellte Charakteristik wird durch das Einschalten des zur Zenerdiode 3 gehörenden parasitären Bipolartransistors verursacht. Dies wird anhand der FIG 3 erläutert:
Die Zenerdioden 3, 4 bestehen aus einer in einen Halbleiterkörper 10 eingebettete Wanne 11 und je einer in die Wanne 11 eingebettete Zone 12 bzw. 13. Sowohl die Wanne 11 als auch die Zonen 12, 13 sind stark dotiert. Beide Zenerdioden haben einen parasitären Bipolartransistor, der durch die Zonen 13, 11, 10 bzw. 12, 11, 10 gebildet wird. Der der Zenerdiode 3 zugeordnete parasitäre npn-Bipolartransistor wurde eingezeichnet und mit 14 bezeichnet. Wird an den Gateanschluß G ein zum Einschalten des Leistungs-MOSFET 1 benötigtes positives Potential angelegt, das stets höher sein muß als das Sourcepotential, so wird der Kollektor des parasitären Bipolartransistors 14 durch die Zone 12, seine Basis durch die Wanne 11 und sein Emitter durch das Substrat 10 gebildet. Die Basis des Bipolartransistors 14 kann dabei auf einem Potential floaten, das höher ist als das Drainpotential. Dann wird der parasitäre Bipolartransistor 14 leitend gesteuert und an der Zenerdiode 3 kann sich nicht die volle Spannung aufbauen.

Der Erfindung liegt die Aufgabe zugrunde, eine Schaltungsanordnung der beschriebenen Art derart weiterzubilden, daß das Einschalten des parasitären Bipolartransistors der genannten Zenerdiode dann vermieden wird, wenn am Eingang des Leistungs-MOSFET eine den MOSFET leitend steuernde Spannung anliegt.

Die Erfindung ist gekennzeichnet durch einen elektronischen Schalter, der die Anodenanschlüsse der Zenerdioden dann mit dem Sourceanschluß des Leistungs-MOSFET verbindet, wenn dessen Gatepotential größer als dessen Source- und Drainpotential ist.

Weiterbildungen der Erfindung sind Gegenstand der Unteransprüche.

Die Erfindung wird anhand eines Ausführungsbeispiels in Verbindung mit FIG 4 erläutert.

In FIG 4 sind die beiden anodenseitig miteinander verbundenen Zenerdioden 3, 4 zwischen den Gateanschluß G und den Sourceanschluß S geschaltet. Der Leistungs-MOSFET 1 wurde hier der Einfachheit halber weggelassen. Der Anodenanschlüsse der Zenerdioder 3, 4 sind über einen elektronischen Schalter mit dem Sourceanschluß S von 1 verbunden. Der elektronische Schalter kann im einfachsten Fall ein Enhancement-FET 15 sein, dessen Sourceanschluß mit den Anodenanschlüssen der Zenerdioden und dessen Drainanschluß mit dem Sourceanschluß S des Leistungs-MOSFET 1 verbunden ist. Sein Gateanschluß G ist mit dem Gateanschluß G des Leistungs-MOSFET 1 verbunden.

Wird nun eine positive Gate-Sourcespannung $U_{GS}$ an den Eingang des Leistungs-MOSFET 1 gelegt, die größer als die Einsatzspannung des FET 15 ist, so wird 15 leitend gesteuert und verbindet den Anodenanschluß der Zenerdiode 3 mit dem Sourceanschluß S des Leistungs MOSFET 1. Das heißt, daß die Basis des parasitären Bipolartransistors 14 (FIG 3) auf das niedrigste vorhandene Potential gelegt wird, das immer niedriger als das Emitterpotential ist. Damit kann der npn-Bipolartransistor 14 nicht einschalten. Die Verbindung der Basis mit dem Sourceanschluß S ist in FIG 3 symbolisch als gestrichelte Linie 17 dargestellt. Die Zenerdiode 3 erhält damit die in FIG 2 durch die gestrichelte Linie 18 dargestellte Strom-Spannungscharakteristik. Die Einsatzspannung des FET 15 wird kleiner als die oder gleich groß wie die Zenerspannung der Zenerdiode 3 gemacht.

Dem MOSFET 15 kann ein Depletion-FET 16 parallelgeschaltet sein derart, daß beide Sourceanschlüsse, beide Drainanschlüsse und ihre Gateanschlüsse miteinander verbunden sind. Der FET 16 ist bei $U_{GS}$ = O bereits leitend und hält die Anodenanschlüsse der Zenerdioden 3, 4 bzw. die Wanne 11 (FIG 3) auch dann auf Sourcepotential, wenn der FET 15 noch nicht eingeschaltet ist.

Wird an den Eingang des MOSFET 1 z.B. durch die Einwirkung einer induktiven Last eine negative Spannung $U_{GS}$ angelegt, so wirkt die Zenerdiode 4 spannungsbegrenzend. Die Transistoren 15, 16 sind dann abgeschaltet. Der der Zenerdiode 4 zugeordnete parasitäre Bipolartransistor stört hier nicht, da beim Anlegen einer $U_{GS}$ < O der Leistungs-MOSFET ohnehin nicht eingeschaltet werden soll.

**Patentansprüche**

1. Schaltungsanordnung mit einem Leistungs-MOSFET und zwei anodenseitig verbundenen Zenerdioden, wobei der Katodenanschluß der ersten Zenerdiode mit dem Gateanschluß und der Katodenanschluß der zweiten Zenerdiode mit dem Sourceanschluß des Leistungs-MOSFET verbunden ist, **qekennzeichnet durch** einen elektronischen Schalter, der die Anodenanschlüsse der Zenerdioden (3, 4) dann mit dem Sourceanschluß (S) des Leistungs-MOSFET 1 verbindet, wenn dessen Gatepotential größer als dessen Source- und Drainpotential ist.

2. Schaltungsanordnung nach Anspruch 1, **dadurch gekennzeichnet,** daß der elektronische Schalter ein Enhancement-MOSFET (15) ist, dessen Sourceanschluß mit dem Anodenanschluß der Zenerdioden (3, 4), dessen Drainanschluß mit dem Sourceanschluß des Leistungs-MOSFET 1 und dessen Gateanschluß mit dem Gateanschluß des Leistungs-MOSFET verbunden ist.

3. Schaltungsanordnung nach Anspruch 2, **dadurch gekennzeichnet,** daß dem Enhancement-MOSFET (15) ein Depletion-MOSFET (16) parallel geschaltet ist derart, daß ihre Sourceanschlüsse, ihre Drainanschlüsse und ihre Gateanschlüsse miteinander verbunden sind.

**Claims**

1. Circuit arrangement having a power MOSFET and two zener diodes connected on the anode side, the cathode terminal of the first zener diode being connected to the gate terminal, and the cathode terminal of the second zener diode being connected to the source terminal of the power MOSFET, characterised by an electronic switch, which connects the anode terminals of the zener diodes (3, 4) to the source terminal (S) of the power MOSFET 1 whenever the gate potential thereof is greater than the source and drain potential thereof.

2. Circuit arrangement according to Claim 1, characterised in that the electronic switch is an enhancement MOSFET (15), whose source terminal is connected to the anode terminal of the zener diodes (3, 4), whose drain terminal is connected to the source terminal of the power MOSFET 1, and whose gate terminal is connected to the gate terminal of the power MOSFET.

3. Circuit arrangement according to Claim 2, characterised in that a depletion MOSFET (16) is connected in parallel to the enhancement MOSFET (15) in such a way that their source terminals, their drain terminals and their gate terminals are connected to one another.

**Revendications**

1. Montage comportant un transistor MOSFET de puissance et deux diodes Zener raccordées au niveau de leurs anodes, la borne de cathode de la première diode Zener étant raccordée à la borne de grille et la borne de cathode de la seconde diode Zener étant raccordée à la borne de source du transistor MOSFET de puissance, caractérisé par un interrupteur électronique qui relie les bornes d'anode des diodes Zener (3,4) à la borne de source (S) du transistor MOSFET de puissance (1) lorsque le potentiel de grille de ce transistor est supérieur à son potentiel de source et de drain.

2. Montage suivant la revendication 1, caractérisé par le fait que l'interrupteur électronique est un transistor MOSFET à enrichissement (15), dont la borne de source est raccordée à la borne d'anode des diodes Zener (3,4), dont la borne de drain est raccordée à la borne de source du transistor MOSFET de puissance (1) et dont la borne de grille est raccordée à la borne de grille du transistor MOSFET de puissance.

3. Montage suivant la revendication 2, caractérisé par le fait qu'en parallèle avec le transistor MOSFET du type à enrichissement (4) est branché un transistor MOSFET du type à appauvrissement (7) de telle façon que leurs bornes de source, leurs bornes de drain et leurs bornes de grille sont reliées entre elles.

## FIG 1

## FIG 2

# FIG 3

# FIG 4

5